Europäisches Patentamt

European Patent Office

Office européen des brevets

(11) Numéro de publication : **0 305 267 B1**

(12) **FASCICULE DE BREVET EUROPEEN**

(45) Date de publication du fascicule du brevet :
04.03.92 Bulletin 92/10

(51) Int. Cl.⁵ : **H05K 3/02, H01Q 15/14**

(21) Numéro de dépôt : **88402098.3**

(22) Date de dépôt : **11.08.88**

(54) **Procédé pour la réalisation d'un ensemble de motifs électriquement conducteurs sur une surface isolante de forme complexe.**

(30) Priorité : **24.08.87 FR 8711851**

(43) Date de publication de la demande :
**01.03.89 Bulletin 89/09**

(45) Mention de la délivrance du brevet :
**04.03.92 Bulletin 92/10**

(84) Etats contractants désignés :
**BE DE ES GB IT NL**

(56) Documents cités :
**DE-B- 2 514 176**
**FR-A- 1 158 793**
**US-A- 3 832 176**

(73) Titulaire : **AEROSPATIALE SOCIETE NATIONALE INDUSTRIELLE Société Anonyme dite:**
**37, Boulevard de Montmorency**
**F-75016 Paris (FR)**

(72) Inventeur : **Clariou, Jean-Pierre**
**8, avenue Nicolas II**
**F-78600 Maisons Laffitte (FR)**

(74) Mandataire : **Bonnetat, Christian et al**
**CABINET BONNETAT 23, Rue de Léningrad**
**F-75008 Paris (FR)**

## Description

La présente invention concerne le procédé pour la réalisation d'un ensemble de motifs électriquement conducteurs sur une surface isolante de forme complexe, par exemple ceux qui sont utilisés pour la réalisation des réflecteurs d'antennes à éléments résonnants discrets répartis sur des surfaces de types conique, parabolique, hyperbolique, etc., ou bien ceux qui entrent dans la structure d'antennes complexes comportant des réflecteurs primaires et des réflecteurs secondaires, comme dans les montages connus des techniciens sous les noms de montages Newton, Cassegrain, etc.

Il existe déjà plusieurs procédés a cet effet. L'un d'eux consiste à réaliser des motifs conducteurs sur un support souple et plan, par exemple un élastomère. Ce support souple est ensuite étiré puis collé sur une forme identique à celle qui doit être obtenue. Un autre procédé consiste à réaliser les motifs conducteurs sur un support rigide, par exemple une bande d'un film en matériau connu sous la désignation KAPTON®. Ce support est ensuite découpé en bandes ou en secteurs de largeur réduite et ainsi plus facilement déformables. Ces bandes sont alors collées sur un substrat ayant la forme définitive choisie. Enfin, on connaît le procédé qui consiste en l'usinage d'une surface métallisée recouverte d'un vernis de protection et superficiellement gravée mécaniquement en suivant le contour des motifs désirés. Les parties qui ne sont pas opérantes sont ensuite éliminées, comme une peau, cette opération étant généralement exécutée manuellement.

Il est évident que ces procédés présentent des inconvénients, par exemple, pour le premier procédé, une mauvaise tenue des motifs conducteurs, particulièrement lors de fortes variations de température. Les deux autres procédés semblent plus fiables, mais la complexité de leur mise en oeuvre ne les rend pas industrialisables et ils ne peuvent être utilisés que ponctuellement.

La présente invention a pour but oeuvre un procédé permettant la réalisation de circuits imprimés présentant une surface complexe, qui pallie les inconvénients des procédés connus, tout en conservant certaines de leurs qualités.

Plus précisément, la présente invention a pour objet un procédé pour la réalisation d'un ensemble de motifs électriquement conducteurs sur une surface électriquement isolante de forme complexe, remarquable en ce que :
– on forme ledit ensemble de motifs sur une face d'un support plan plastiquement déformable ;
– on applique en le déformant ledit support plan contre ladite surface de forme complexe ; et
– on solidarise ledit support plan déformé et ladite surface de forme complexe.

Les figures du dessin annexé feront bien comprendre comment l'invention peut être réalisée. Sur ces figures, des références identiques désignent des éléments semblables.

La figure 1 représente un réflecteur d'antenne dans lequel le produit obtenu par le procédé selon l'invention trouve une application particulièrement avantageuse.

Les figures 2 à 7 représentent des schémas illustrant les différentes étapes successives d'une mise en oeuvre du procédé selon l'invention.

Les figures 8 à 12 représentent différentes réalisations qui peuvent être obtenues avec le procédé selon l'invention.

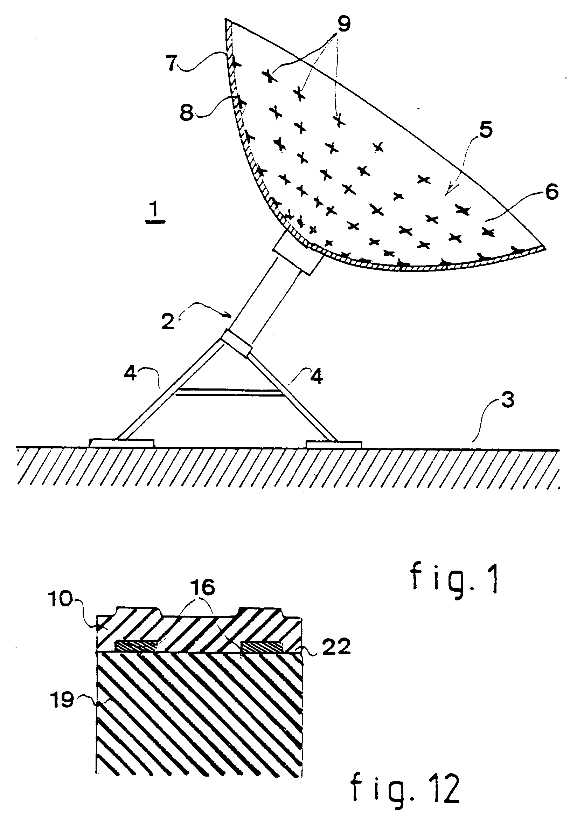

La présente invention concerne un procédé de réalisation d'un ensemble de motifs électriquement conducteurs sur une surface isolante de forme complexe. Ces motifs électriquement conducteurs ont une très grande importance dans les techniques modernes et sont notamment couramment utilisés dans des réflecteurs d'antennes 1 comme celui illustré sur la figure 1. Ce réflecteur 1 est monté sur un support 2, lequel coopère avec une surface d'appui 3 par l'intermédiaire de bras 4. Le réflecteur 1 présente une surface non développable en forme, par exemple, de paraboloïde 5. La surface 6 de ce paraboloïde est constituée d'un support 7 en un matériau électriquement isolant comportant en surface 8 des motifs 9 qui sont, eux, électriquement conducteurs. A titre d'exemple, il a été représenté des motifs en forme de croix, mais il est évident que ces motifs peuvent être de toutes autres formes nécessaires aux techniciens.

Pour la réalisation de tels motifs électriquement conducteurs, on utilise avantageusement le procédé tel que décrit ci-après qui, par rapport aux procédés selon l'art antérieur, donne de très bons résultats, mais qui présente en plus l'avantage de pouvoir être industrialisé pour des productions en grandes quantités.

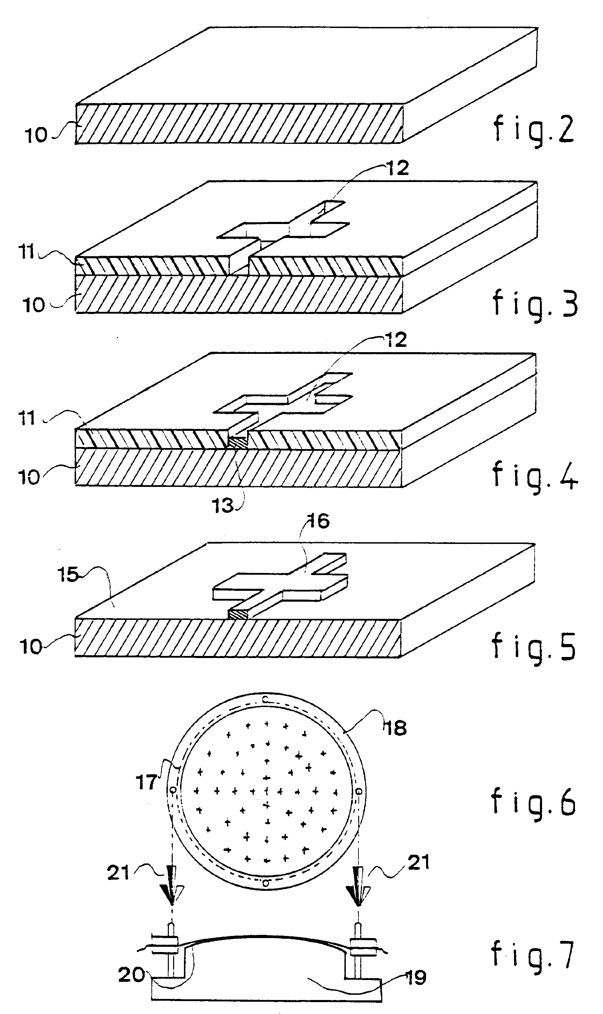

Les différentes phases principales du procédé sont représentées sur les figures 2 à 7.

Le procédé consiste, dans une première étape, à réaliser un premier support plan 10 d'une dimension voisine de celle qui doit être obtenue pour la réalisation de la surface complexe, figure 2. Ce premier support doit être déformable et, s'il est en un matériau métallique, doit pouvoir être recuit. C'est ainsi qu'il peut être constitué d'une feuille de cuivre ayant une épaisseur de l'ordre de 10 à 40 microns.

Ensuite, dans une deuxième étape, figure 3, sur ce premier support 10 est déposée une couche d'un premier matériau donné 11, par exemple un vernis, en délimitant, dans ce premier matériau, des zones 12 correspondant à la forme d'un circuit donné. Pour obtenir ces zones 12, il est possible de déposer le premier matériau sur toute la surface du premier support et ensuite y définir les zones, par exemple par photogravure ou par sérigraphie.

A titre d'exemple, la forme du circuit illustrée est une croix, mais il est bien évident qu'elle peut être tout autre, circulaire, elliptique, carrée, etc.

Quand cette deuxième étape est terminée, dans une troisième étape, un deuxième matériau 13 est déposé dans ces zones pour en tapisser tout le fond, sur une épaisseur plus faible que celle du premier matériau 11, figure 4. A titre d'exemple, ce deuxième matériau peut être de l'or, de l'argent, du nickel, de l'aluminium ou de l'étain qui sont des matériaux électriquement bon conducteurs et parmi ceux qui sont le plus avantageusement utilisés pour l'application mentionnée ci-avant, et l'épaisseur peut être de quelques microns. De plus, si le deuxième matériau 13 est l'un des trois précédemment cités, son dépôt peut être avantageusement effectué par un procédé électrochimique présentant l'avantage, en même temps, de solidariser, la couche de ce deuxième matériau avec la surface du premier support 10.

Arrivé à ce stade, le procédé consiste alors, dans une quatrième phase, à éliminer la couche du premier matériau 11, sans éliminer le deuxième matériau 13, figure 5. Pour ce faire, les deux matériaux sont choisis pour être respectivement attaquable et non attaquable par un certain produit. Dans le cas où le premier matériau est un vernis et le second de l'or, la couche 11 peut être aisément éliminée par l'action d'un solvant n'attaquant pas l'or. Cette technique est d'ailleurs bien connue en elle-même et ne sera donc pas décrite plus amplement.

A ce stade, il est donc obtenu un support 10, toujours plan, comportant, en relief sur une face 15, l'ensemble des motifs 16 ayant la forme des zones qui avaient été définies dans la couche du premier matériau 11 primitivement déposée sur cette face 15.

Dans une cinquième étape, les bords 17 du premier support 10 comportant les motifs 16 sont pincés fermement dans un cadre 18, figure 6, et l'ensemble de ces deux éléments, support 10 et motifs 16, est appliqué sur un deuxième support 19, par exemple un substrat en matériau composite renforcé de fibres de verre ou de fibres aramides comme celles connues sous le nom commercial de KEVLAR. Ce support 19 est tel que sa face 20 ait le profil de la forme complexe de la surface du circuit imprimé devant être finalement obtenu. Sur le cadre 18 sont alors appliqués des efforts schématisés par les flèches 21, pour déformer le premier support 10 et lui donner la forme de cette surface complexe 20, en le plaquant contre la face 20 du second support 19.

Bien entendu, L'ensemble des deux éléments, premier support et motifs, est solidarisé par tous moyens, par exemple de la colle qui aurait été préalablement étalée sur la face 20 du deuxième support 19.

Dans l'exemple illustré, la forme complexe est une surface convexe mais elle pourrait être de toute autre forme.

Quand cette cinquième étape est terminée, le matériau du premier support 10 est éliminé, de façon à ne conserver, sur le deuxième support en matériau non électriquement conducteur, que les motifs 16 prédéterminés en matériau conducteur. Si le premier support est en cuivre et les motifs en or, le cuivre est éliminé par attaque chimique avec une solution de perchlorure de fer ou une solution d'alcali. Cette opération pourrait être aussi utilisée avec un premier support en aluminium.

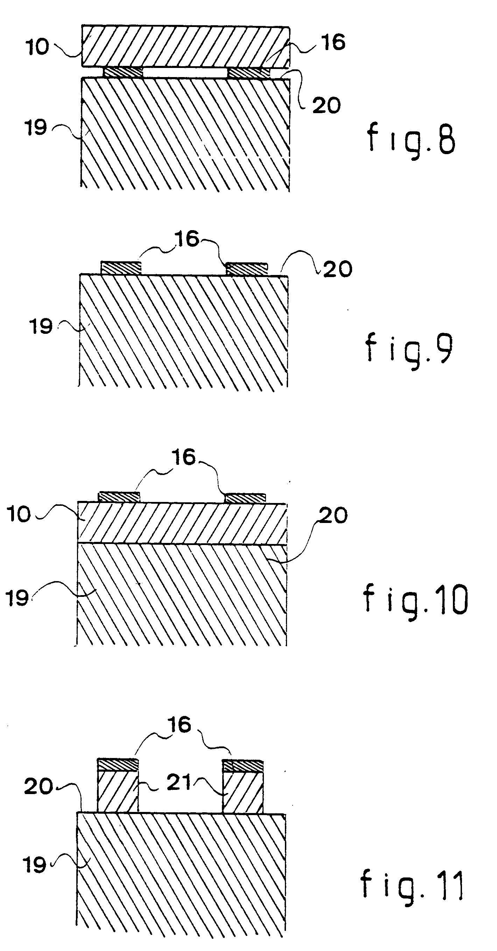

Sur les figures 8, 9 et 10, 11 sont représentés deux modes d'application du premier support 10 supportant les motifs 16 sur le deuxième support 19 en matériau non conducteur.

Les figures 8 et 9 représentent un premier mode d'application. L'ensemble comprenant le premier support 10 avec les motifs 16 est appliqué sur la face 20 du deuxième support, de façon que les motifs 16 soient au contact de cette face, par exemple collés sur celle-ci, figure 8. Dans ce cas, le premier support est attaqué par le produit chimique et, en définitive, sur la face 20 du deuxième support, il ne reste plus que les motifs 16, figure 9.

Les figures 10 et 11 représentent un autre mode d'application selon lequel l'ensemble du support 10 et des motifs 16 est disposé sur le deuxième support 19 de façon que le premier support 10 soit lui-même directement collé sur la face 20 de ce deuxième support. Le matériau du premier support est ensuite attaqué chimiquement de la même façon que précédemment. Cependant, dans ce cas, les motifs 16 restent situés sur des colonnes 21 en matériau du premier support provenant des parties de ce premier support qui n'ont pas été attaqueés chimiquement, du fait qu'elles étaient protégées par le matériau des motifs 16 qui, lui, est inattaquable par le produit chimique choisi pour éliminer le matériau du premier support.

Il est à préciser que les figures n'ont été élaborées que pour illustrer les différentes étapes de la mise en oeuvre du procédé et mieux faire comprendre celui-ci, mais qu'en aucune façon elles ne veulent donner une parfaite représentation, à l'échelle, des différentes épaisseurs des différentes couches de matériaux.

Dans l'exemple de mise en oeuvre donné ci-avant, et jusqu'au résultat final tel qu'illustré par les figures 8 et 9, il est parfois avantageux de choisir le premier support en un matériau de type organique, tel qu'une résine thermoplastique. Dans ce cas, l'ensemble premier support 10 et motifs 16 est avantageusement disposé sur le deuxième support 19 selon le mode d'application illustré par la figure 8. En effet, le matériau constituant le premier support n'étant pas conducteur électrique, il n'est pas nécessaire de l'éliminer, et si, de plus, le deuxième support est choisi dans ce même matériau, figure 12, l'adhérence des motifs peut être obtenue par chauffage simultané des deux supports jusqu'à obtenir au moins une fusion partielle 22 entre eux, les motifs 16 se trouvant alors emprisonnés dans ce matériau non conducteur les protégeant de toute action d'agents extérieurs, ce qui permet de les réaliser dans n'importe quel matériau conducteur, même oxydable.

La description donnée ci-dessus fait apparaître tous les avantages du procédé selon l'invention, en particulier le fait qu'il permet de résoudre les problèmes posés dans la technologie moderne pour obtenir une production industrielle de circuits imprimés disposés sur des surfaces complexes très difficilement développables, en particulier pour la réalisation de réflecteurs d'antennes dont un a été choisi, dans la description, à titre d'exemple d'application.

## Revendications

1. Procédé pour la réalisation d'un ensemble de motifs (9,16) électriquement conducteurs sur une surface électriquement isolante (20) de forme complexe, caractérisé en ce que :
   – on forme ledit ensemble de motifs (16) sur une face d'un support plan plastiquement déformable (10) ;
   – on applique en le déformant ledit support plan (10) contre ladite surface (20) de forme complexe ; et
   – on solidarise ledit support plan (10) déformé et ladite surface (20) de forme complexe.

2. Procédé selon la revendication 1, caractérisé en ce que ledit support plan plastiquement déformable (10) est une feuille de cuivre recuit.

3. Procédé selon la revendication 1, caractérisé en ce que ledit support plan plastiquement déformable (10) est une feuille de résine thermoplastique.

4. Procédé selon l'une quelconque des revendications 2 ou 3, caractérisé en ce que ledit support plan plastiquement déformable (10) a une épaisseur comprise entre 10 et 40 microns.

5. Procédé selon l'une des revendications 1 ou 2, caractérisé en ce que ledit support plan déformable (10) est appliqué contre ladite surface (20) de forme complexe et solidarisé de celle-ci par sa face portant lesdits motifs (16) et en ce que l'on élimine totalement ledit support plan déformé.

6. Procédé selon l'une des revendications 1 ou 2, caractérisé en ce que ledit support plan déformable (10) est appliqué contre ladite surface (20) de forme complexe et solidarisé de celle-ci par sa face opposée à celle portant lesdits motifs (16) et en ce que l'on élimine ledit support plan déformé, sauf à l'aplomb desdits motifs (16).

7. Procédé selon l'une des revendications 1 ou 3, caractérisé en ce que ledit support plan déformable (10) est en une matière électriquement isolante et est appliqué contre ladite surface (20) de forme complexe et solidarisé de celle-ci par sa face opposée à celle portant lesdits motifs (16) et en ce que ledit support est maintenu sur ladite surface comme protection desdits motifs (16).

8. Procédé selon l'une quelconque des revendications 1 à 7, caractérisé en ce que :
   – on dépose sur ledit support plan (10) une première couche (11) dans laquelle on pratique un ensemble d'évidements (12) en correspondance avec ledit ensemble de motifs (16) ;
   – on dépose dans lesdits évidements (12) une seconde couche électriquement conductrice (13) ; et
   – on élimine ladite première couche.

9. Procédé selon l'une quelconque des revendications 1 ou 2, caractérisé en ce que la solidarisation dudit support plan déformé sur ladite surface (20) de forme complexe est réalisée par collage.

10. Procédé selon l'une quelconque des revendications 1 ou 3, caractérisé en ce que la solidarisation dudit support plan déformé sur ladite surface (20) de forme complexe est réalisé par fusion par chauffage.

11. Procédé selon l'une quelconque des revendications 5 ou 6, caractérisé en ce que l'élimination dudit support plan déformé est réalisée par attaque chimique.

12. Procédé selon l'une quelconque des revendications 1 à 11, caractérisé en ce que lesdits motifs (16) sont réalisés en un métal tel que l'or, l'argent, le nickel, l'aluminium et l'étain.

13. Procédé selon l'une quelconque des revendications 1 à 12, caractérisé en ce que lesdits motifs (16) sont réalisés par dépôt chimique ou électrochimique.

14. Procédé selon la revendication 8, caractérisé en ce que lesdits évidements (12) sont délimités par photogravure ou sérigraphie.

## Patentansprüche

1. Verfahren zur Herstellung einer Gesamtheit elektrisch leitender Muster (9, 16) auf einer elektrisch isolierenden, komplex geformten Oberfläche (20), dadurch gekennzeichnet,
   – daß die genannte Gesamtheit von Mustern (16) auf einer Fläche eines ebenen, plastisch verformbaren Trägers (10) gebildet wird;
   – daß der genannte ebene Träger (10) unter Verformung auf die genannte komplex geformte Oberfläche (20) aufgebracht wird; und
   – daß der genannte ebene, verformte Träger (10) mit der genannten komplex geformten Oberfläche (20) fest verbunden wird.

2. Verfahren gemäß Anspruch 1, dadurch gekennzeichnet, daß der genannte ebene, plastisch verformbare Träger (10) eine Folie aus geglühtem Kupfer ist.

3. Verfahren gemäß Anspruch 1, dadurch gekennzeichnet, daß der genannte ebene, plastisch verformbare Träger (10) eine Folie aus einem thermoplastischen Kunststoff ist.

4. Verfahren gemäß Anspruch 2 oder Anspruch 3, dadurch gekennzeichnet, daß der genannte ebene, plastisch verformbare Träger (10) eine Dicke zwischen 10 und 40 µm aufweist.

5. Verfahren gemäß Anspruch 1 oder Anspruch 2, dadurch gekennzeichnet, daß der genannte ebene, verformbare Träger (10) mit seiner die genannten Muster (16) tragenden Fläche auf die genannte komplex geformte Oberfläche (20) aufgebracht und mit dieser fest verbunden wird und daß der genannte ebene, verformte Träger vollständig entfernt wird.

6. Verfahren gemäß Anspruch 1 oder Anspruch 2, dadurch gekennzeichnet, daß der genannte ebene, verformbare Träger (10) mit der Fläche, welche der die genannten Muster (16) tragenden gegenüberliegt, auf die genannte Oberfläche (20) aufgebracht und mit dieser fest verbunden wird und daß der genannte ebene, verformte Träger außer unter den genannten Mustern (16) entfernt wird.

7. Verfahren gemäß Anspruch 1 oder Anspruch 3, dadurch gekennzeichnet, daß der genannte ebene, verformbare Träger (10) aus einem elektrisch isolierenden Werkstoff besteht und mit der Fläche, welche der die genannten Muster (16) tragenden gegenüber liegt, auf die genannte komplex geformte Oberfläche (20) aufgebracht und mit dieser fest verbunden wird und daß der genannte Träger als Schutz für die genannten Muster (16) auf der genannten Oberfläche verbleibt.

8. Verfahren gemäß einem beliebigen der Ansprüche 1 bis 7, dadurch gekennzeichnet,
– daß auf den genannten ebenen Träger (10) eine erste Schicht (11) aufgetragen wird, in der eine Gesamtheit von Aussparungen (12), welche der genannten Gesamtheit von Mustern (16) entspricht, angebracht wird;
– daß in die genannten Aussparungen (12) eine zweite, elektrisch leitende Schicht (13) eingebracht wird; und
– daß die genannte erste Schicht entfernt wird.

9. Verfahren gemäß Anspruch 1 oder Anspruch 2, dadurch gekennzeichnet, daß die feste Verbindung des genannten ebenen, verformten Trägers mit der genannten komplex geformten Oberfläche (20) durch Kleben hergestellt wird.

10. Verfahren gemäß Anspruch 1 oder Anspruch 3, dadurch gekennzeichnet, daß die feste Verbindung des genannten ebenen, verformten Trägers mit der genannten komplex geformten Oberfläche (20) durch Schmelzen mittels Erhitzens erfolgt.

11. Verfahren gemäß Anspruch 5 oder Anspruch 6, dadurch gekennzeichnet, daß das Entfernen des genannten ebenen, verformten Trägers durch chemischen Angriff erfolgt.

12. Verfahren gemäß einem beliebigen der Ansprüche 1 bis 11, dadurch gekennzeichnet, daß die genannten Muster (16) in einem Metall wie z.B. Gold, Silber, Nickel Aluminim oder Zinn ausgeführt werden.

13. Verfahren gemäß einem beliebigen der Ansprüche 1 bis 12, dadurch gekennzeichnet, daß die genannten Muster (16) durch chemischen oder elektrochemischen Niederschlag hergestellt werden.

14. Verfahren gemäß Anspruch 6, dadurch gekennzeichnet, daß die genannten Aussparungen 12 durch Photoätzung oder Siebdruck festgelegt werden.

## Claims

1. Process for making an assembly of electrically conductive patterns (9,16) on an electrically insulating surface (20) of complex form, characterized in that :
– said assembly of patterns (16) is formed on a face of a plastically deformable flat support (10) ;
– said flat support (10) is applied, by being deformed, against said surface (20) of complex form ; and
– said deformed flat support (10) is connected to said surface (20) of complex form.

2. Process according to claim 1, characterized in that said plastically deformable flat support (10) is a foil of annealed copper.

3. Process according to claim 1, characterized in that said plastically deformable flat support (10) is a foil of thermoplastics resin.

4. Process according to either one of claims 2 or 3, characterized in that said plastically deformable flat support (10) has a thickness of between 10 and 40 microns.

5. Process according to one of claims 1 or 2, characterized in that said deformable flat support (10) is applied against said surface (20) of complex shape and connected therewith by its face bearing said patterns (16) and in that said deformed flat support is totally eliminated.

6. Process according to one of claims 1 or 2, characterized in that said deformable flat support (10) is applied against said surface (20) of complex shape and connected therewith by its face opposite the one bearing said patterns (16), and in that said deformed flat support is eliminated, except plumb with said patterns (16).

7. Process according to one of claims 1 or 3, characterized in that said deformable flat support (10) is made of an electrically insulating material and is applied against said surface (20) of complex shape and connected therewith by its face opposite the one bearing said patterns (16), and in that said support is maintained on said surface as protection of said patterns (16).

8. Process according to any one of claims 1 to 7, characterized in that :

– there is deposited on said flat support (10) a first layer (11) in which is made an assembly of recesses (12) in register with said assembly of patterns (16) ;

– there is deposited in said recesses (12) a second electrically conductive layer (13) ; and

– said first layer is eliminated.

9. Process according to either one of claims 1 or 2, characterized in that connection of said deformed flat support on said surface (20) of complex shape is effected by gluing.

10. Process according to either one of claims 1 or 3, characterized in that connection of said deformed flat support on said surface (20) of complex shape is effected by fusion by heating.

11. Process according to either one of claims 5 or 6, characterized in that elimination of said deformed flat support is effected by chemical attack.

12. Process according to any one of claims 1 to 11, characterized in that said patterns (16) are made of a metal such as gold, silver, nickel, aluminium and tin.

13. Process according to any one of claims 1 to 12, characterized in that said patterns (16) are made by chemical or electro-chemical deposit.

14. Process according to claim 8, characterized in that said recesses (12) are defined by photo-engraving or serigraphy.

fig. 1

fig. 12

fig.2

10

fig.3

12

11

10

fig.4

12

11

10

13

fig.5

16

15

10

fig.6

18

17

21 21

fig.7

20 19

8

fig.8

fig.9

fig.10

fig.11